Europäisches Patentamt

(19) European Patent Office

Office européen des brevets

(11) Publication number: **0 040 629 B1**

(12) **EUROPEAN PATENT SPECIFICATION**

(45) Date of publication of patent specification: **30.12.86**

(21) Application number: **81900097.7**

(22) Date of filing: **20.10.80**

(86) International application number:
**PCT/US80/01384**

(87) International publication number:
**WO 81/01629 11.06.81 Gazette 81/14**

(51) Int. Cl.⁴: **H 01 L 23/48,** H 01 L 29/40,
H 01 L 29/46, H 01 L 29/64

(54) **FINE-LINE SOLID STATE DEVICE.**

(30) Priority: **30.11.79 US 98979**

(43) Date of publication of application:
**02.12.81 Bulletin 81/48**

(45) Publication of the grant of the patent:
**30.12.86 Bulletin 86/52**

(84) Designated Contracting States:
**DE FR**

(56) References cited:
**US-A-3 743 894**
**US-A-3 754 168**
**US-A-3 830 657**
**US-A-3 833 842**
**US-A-3 879 840**
**US-A-4 017 890**
**US-A-4 027 326**
**US-A-4 062 720**
**US-A-4 166 279**

(73) Proprietor: **Western Electric Company,**
**Incorporated**
**222 Broadway**
**New York, NY 10038 (US)**

(72) Inventor: **SHENG, Tan Tsu**
**14 Ferndale Drive**
**Berkeley Heights, NJ 07922 (US)**
Inventor: **SINHA, Ashok Kumar**
**36 Fox Run**
**Murray Hill, NJ 07974 (US)**
Inventor: **VAIDYA, Sheila**
**161 Ryder Way**
**New Providence, NJ 07974 (US)**

(74) Representative: **Watts, Christopher Malcolm**
**Kelway, Dr. et al**
**Western Electric Company Limited**
**5, Mornington Road**
**Woodford Green Essex, IG8 0TU (GB)**

Courier Press, Leamington Spa, England.

(58) References cited:

JOURNAL OF APPLIED PHYSICS, vol. 49, no. 7, July 1978, pages 4083-4093, American Institute of Physics, New York, US, J.K. HOWARD et al.: "Intermetallic compounds of Al and transitions metals: Effect of electromigration in 1-2-mum-wide lines"

13th ANNUAL PROCEEDINGS OF THE RELIABILITY PHYSICS, 1st-3rd April 1975, Las Vegas, Nevada, pages 151-158, IEEE, New York, US, G.A. SCOGGAN et al.: "With dependence of electromigration life in Al-Cu, Al-Cu-Si, and Ag conductors"

THIN SOLID FILMS, vol. 45, no. 1, August 1977, pages 69-84, Elsevier Sequoia S.A., Lausanne, printed in NL, P.B. GHATE et al.: "Metallization in microelectronics"

SOLID-STATE TECHNOLOGY, vol. 21, no. 11, November 1978, pages 49-54, New York, US, F. HEGNER et al.: "Aluminum-silicon metallization by rate controlled dual EB-gun evaporation"

**Description**

One of the limitations to the realization of very dense semiconductor integrated circuit is that aluminum and aluminum alloy electrical conductors, which are required to carry high currents, sometimes develop open circuit conditions during use even after testing. These open circuit problems have been attributed to electromigration-induced failures as is now well understood in the art. Electromigration damage has been found to be held to tolerable limits if conductor widths of seven microns or greater are used for current density level required by practical devices. But such a limitation constrains the effort to reach higher packing densities.

Conductor width dependence of electromigration life in Al-Cu, Al-Cu-Si, and Ag conductors is discussed in an article so entitled, by G. A Scoggan, B. N. Agarwala, P. P. Peressini, and A. Brouillard appearing on page 151 in *The Proceedings of the 13th Reliability Physics Symposium, IEEE*, New York, 1975, page 151. That reference describes the effect of varying crystallographic grain size and conductor width on lifetime and illustrates that, as the conductor width is decreased, the electromigration lifetime approaches a saturation level or even exhibits a weak minimum. A grain is a monocrystalline region within the conductor, the paper concludes that large grain size leads to improved lifetimes for short, narrow lines. On the other hand, it is clear from the publication that lines even as narrow as one micron would contain structural defects or divergent sites causing electromigration failures. Consequently, even lines with large grain size are limited in their usual lengths. The above-mentioned publication notes also the desirability of an ideal bamboo or chain geometry for the grain structure in electrical conductors. A chain geometry is a regular succession of grains, while a bamboo geometry is a chain geometry in which each successive grain extends across the entire width of the conductor. *The Journal of Applied Physics*, Vol. 41, No. 10, Sept. 1970, at page 3954 et seq. documents the decreasing electromigration life with increasing length.

US—A—4017890 discloses an electrical conductor for a circuit as set out in the preamble to the main claim. The conductor consists of aluminum layers with a layer of an intermetallic compound of aluminum and a transition metal sandwiched between them. The intermetallic compound acts as a barrier to electromigration. The aluminum layer above the compound layer has a grain structure with a strongly preferred orientation. The grain size is small, which is considered to be an advantage. The lifetime due to electromigration is enhanced, but the resistivity is increased by the intermetallic compound and the fabrication process is rendered more complex by the necessity of making multiple layers.

In the invention as claimed enhanced lifetime is obtained without the associated disadvantages.

Brief Description of the Drawing

FIG. 1 is a schematic plan view of an illustrative integrated circuit in accordance with this invention;

FIGS. 2 and 3 are enlarged top and schematic views respectively of portions of the circuit of Fig. 1;

FIG. 4 is an enlarged top view of a portion of the circuit of Fig. 1 made in accordance with this invention;

FIG. 5 is a flow diagram of a process for making the device of Figs. 1—4;

FIG. 6 is a graph of the electromigration characteristic of prior art circuits;

FIG. 7 is a graph of electromigration lifetime data for a variety of deposited Al lines;

FIG. 8 is a graph of the electromigration characteristics of the circuits of Figs. 1—4 compared to like prior art circuits; and

FIG. 9 is a top view of an alternative embodiment in accordance with this invention.

Detailed Description

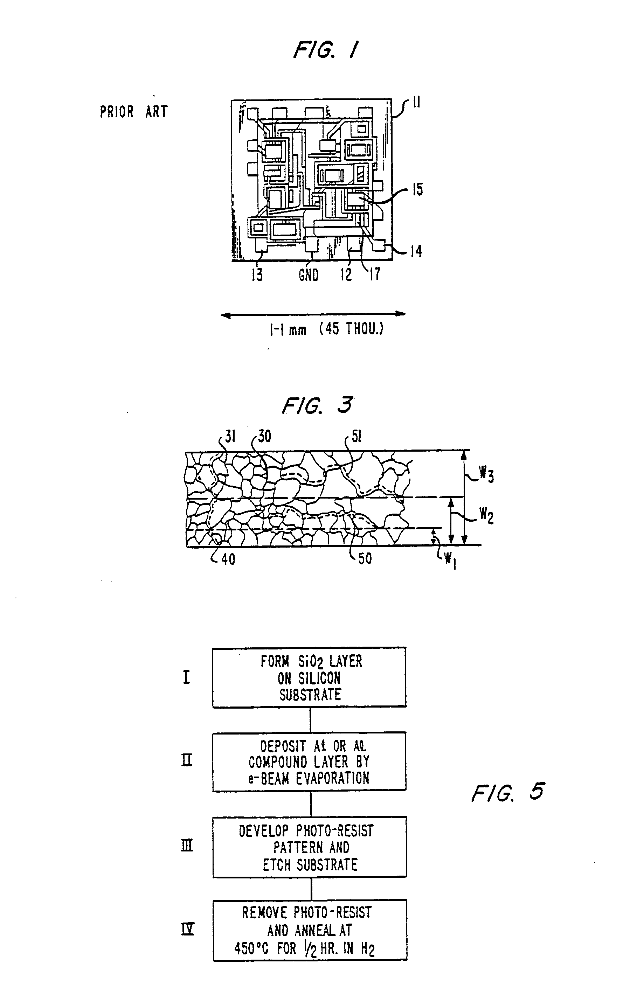

Fig. 1 shows a typical commercial integrated circuit 10 defined in a chip 11 of semiconductor material such as silicon. The circuit includes a pattern of electrically conducting material extending between active semiconductor regions and "lands" to which external electrical connections are made. Illustrative lands are designated 12, 13, 14 and ground (GND) in the figure. Attention is directed to illustrative conductor 17 extending between land 12 and active region 15.

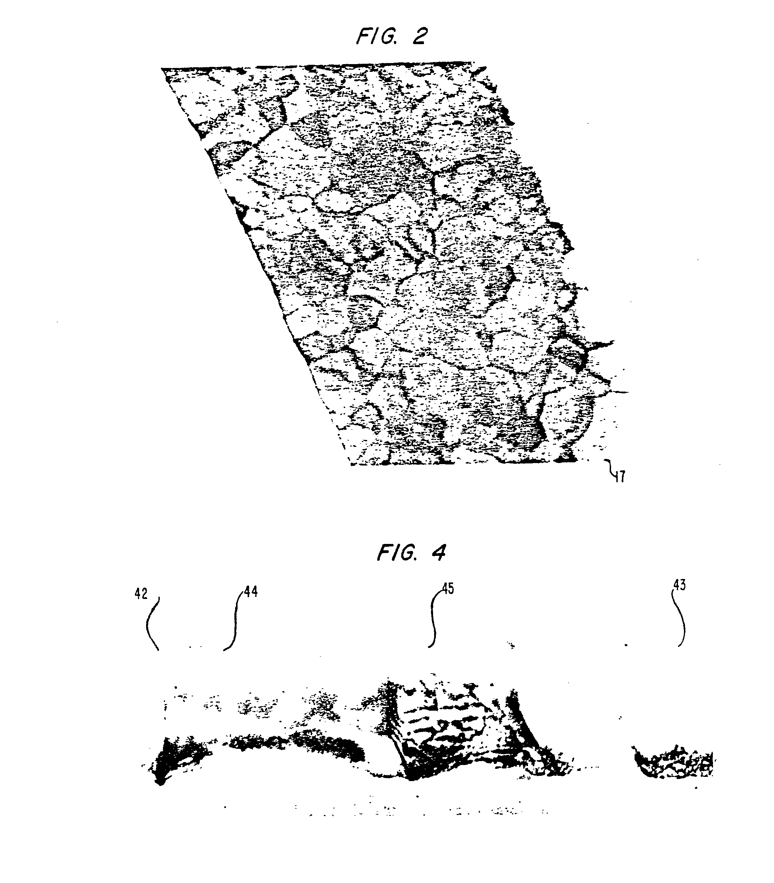

Fig. 2 shows a micrograph of the grain structure of a typical conductor 17 of a standard integrated circuit. Such conductors typically have a width of seven microns or greater, in commercial circuits. A large number of grains can be seen spanning the conductor width. The grain size in this case clearly is small compared to the width of the conductor.

Fig. 3 shows, schematically, a typical grain pattern which corresponds, for example, to that of conductor 17. The intersection of three grain boundaries forms a "triple point" or "divergent site". Voids usually form at heterogeneities in structure such as, for example, grain boundary triple points, 30 and 31 in Fig. 3, by the electromigration of atoms along the direction of current flow away from these sites. One such path for electromigration, composed of grain boundary segments, may be represented by dotted line 50 in Fig. 3. Another may be represented by dotted line 51. It is clear that with many triple points and many such paths for electromigration, open circuits result fairly easily.

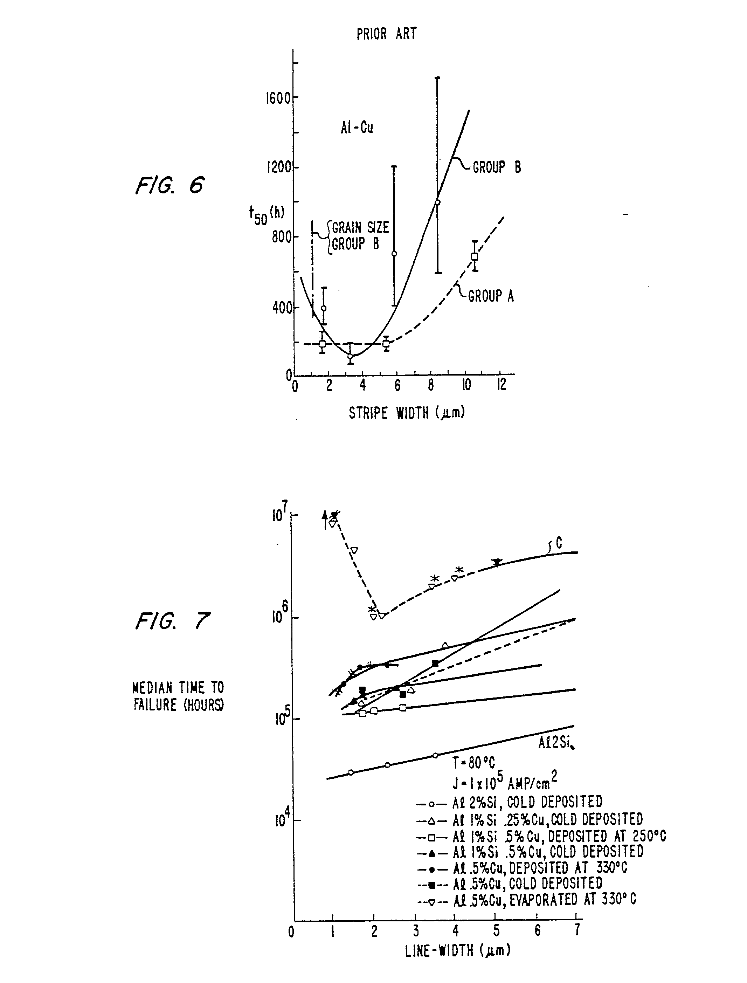

Fig. 4 is a micrograph of the grain structure of one micron wide electrical conductors such as 17 of Figs. 1 and 2 achieved by the process of Fig. 5 herein. The grain size is generally larger than the width of the conductor. Some of these grains are designated 42, 43, 44 and 45 in Fig. 4. Clearly, no triple point, exist. In addition, there are no grain boundary heterogeneities which could contribute to void formation and failure. A thin film conductor pattern having a chain type grain structure would approach an ideal (bamboo) structure as far as electromigration characteristics are concerned. Such structures are achieved with the lengths suitable for commercial use by the processes of Fig. 5.

The first step of the process is to form an $SiO_2$ layer 0.5 microns (μm) thick on a processed silicon substrate as indicated by block I of Fig. 5. The second step is to deposit 99.5% Al-0.5% Cu by electron gun evaporation onto a hot surface (approximately 300 degrees C) as indicated by block II. A photoresist layer is deposited, exposed, developed and etched to form lines of the kind shown in Fig. 2. This step is represented by the block of Fig. 3. The etched pattern is annealed in hydrogen at 450 degrees C for about one-half hour to form the bamboo structure of the line shown in Fig. 4.

The grains 42, 43, 44, 45 labeled in Fig. 4, are all oriented with the {111} direction perpendicular to the surface of the $SiO_2$ layer. Only with grains in the same direction can lines of the order of a centimeter in length have such attractive electromigration characteristics. The process of Fig. 5 produces the chain structure, the requisite preferred crystal orientation and the resulting attractive characteristics. The e-gun evaporation produces a film with atoms possessing a high degree of mobility for later recrystallization in a preferred direction upon annealing.

Fig. 6 shows a prior art plot of strip width in microns versus lifetime for two groups of material A and B taken from the above referenced *IEEE Proceedings.* An increase in the characteristic mean time to failure ($t_{50}$) below three micron line width is shown for Group B materials. The grain size for Group B materials is about one micron as indicated in the figure. Improvement seems to be achieved for mean grain sizes of less than the line width as well as about equal to the line width. The reason for the improvement is offered in connection with Fig. 3. Line widths $w_1$, $w_2$ and $w_3$ are indicated by brokenlines as seen. A path such as 50 or 51 exists in each of the lines $w_2$ and $w_3$ for electromigration and resulting void formation. Even in the line of narrow width $w_1$, although single grains may span the entire width of the conductor, a number of divergent sites still occur for void formation.

This is not the case in lines made according to the process of Fig. 5. The cleanliness of the $SiO_2$ surface, the process of metal deposition and the final annealing of the pattern cooperate to achieve the {111} orientation of the grains and also the requisite chain structure. Others who have had a final annealing step in their process for making fine-line structures have not realized the chain structure with alike grain orientation achieved herein. When grains have the same crystallographic orientation their boundaries are more uniform in properties leading to a reduced number of divergent sites for void growth.

Fig. 7 plots mean time to failure versus line width. The improvement achieved herein by lines with bamboo-like structures is represented by curve C in Fig. 7. The remaining lines in the figure represent data taken for different test materials and deposition techniques according to the legend in the figure. One e-gun evaporated materials showed the improvement represented line C.

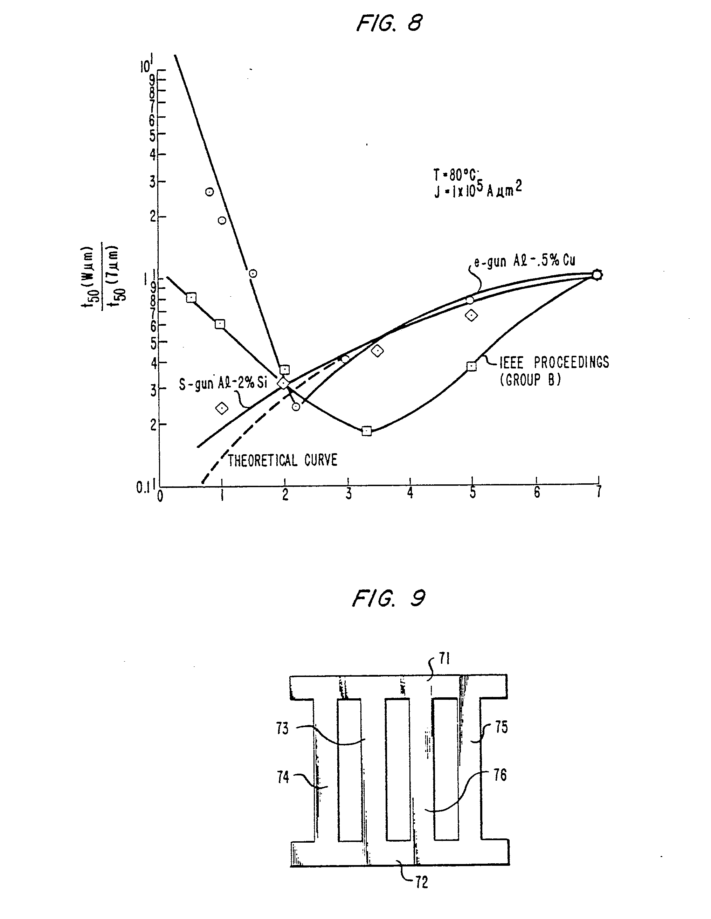

Fig. 8 is a plot of the ratio of lifetime at width $w$ to that at 7 microns versus line width for prior art lines and for data from experimentation with lines made in accordance with the process of Fig. 5. The plot is similar to that of Fig. 7, but the data is normalized to the lifeline at 7 microns so that all curves go to the value 1 (one) as shown. The curve for Group B materials in Fig. 6 (from the *IEEE Proceedings*) is redrawn in Fig. 8 as indicated. An electromigration lifetime minimum is shown at slightly over three microns with a modest increase for narrower lines. Aluminum deposition by sputter gun evaporation approximately follows the theoretical (shown in *The IEEE Reliability Physics Symposium 1978,* at page 233, by J. R. Black) curve so designated in the figure. Lines with like grain orientations were characterized by dramatically high lifetimes at narrow line widths as shown by a representative curve designated "e-gun Al-.5% Cu". The data for Fig. 8 was determined for nominal device operating conditions of 80 degrees C and a current density of $1 \times 10^5$ amperes/cm$^2$.

In one specific test arrangement, lines having widths of 1 micron showed an unexpected and suprisingly large electromigration lifetime of $1 \times 10^7$ h (hours) at 80 degrees C and a current density of $1 \times 10^5$ A/cm$^2$. These lifetimes were estimated from accelerated aging data obtained at 250 degrees C for a current density of $2 \times 10^6$ A/cm$^2$ and conservatively assuming a thermal activation energy of 0.5 electron volts. It was found generally that films with widths of 1.5 microns and less had very long lifetimes of $4 \times 10^6$ hours or greater.

As is also clear from curve C of Fig. 7 (and the e-gun curve of Fig. 8) much higher lifetimes are achieved for narrower lines with chain-shaped grain structures herein than for relatively wide lines. Consequently, an electrically conducting pattern as shown in Fig. 9 is attractive where first and second lands (or one land and an active region) 71 and 72 are interconnected by a plurality of electrically conducting lines 73, 74, 75 and 76, of say one micron width rather than a single line of say seven micron width.

The embodiments described herein are considered merely illustrative of the principles of this invention. Therefore, those skilled in the art can devise various modifications thereof within the scope of the invention as encompassed by the following claims. For example, although the invention has been described in connection with a {111} grain orientation, like grain orientations other than {111} are possible. A layer of another

metal over the SiO₂ surface is known in this connection to permit such other orientation.

It is to be clear that the invention may be practiced with other solid state devices such as magnetic bubble devices.

## Claims

1. A solid state device including a layer having a first surface and pattern of electrically conducting lines thereon, each of said lines having crystallographic grains (42—45) preferentially oriented in a like crystallographic direction, characterised in that the grain structure is in the form of a bamboo-like chain and the said preferential orientation is substantially complete.

2. A solid state device in accordance with claim 1 wherein the said grains are oriented in a {111} direction.

3. A solid state device in accordance with claim 1 or 2 wherein the said layer comprises SiO₂ and said pattern is made from aluminium or an aluminium alloy.

4. A solid state device in accordance with claim 3 wherein the said SiO₂ layer is formed on a semiconductor substrate.

5. A solid state device in accordance with claim 4 wherein the said substrate is of silicon.

6. A process for forming a conductor pattern on a silicon dioxide surface comprising the steps of depositing a layer of aluminium or an aluminium alloy on the surface by electron gun evaporation, etching the layer to form the pattern and annealing the layer after etching characterised in that the layer is deposited onto a hot surface and the said annealing is at a temperature and for a time to form a bamboo-type grain structure.

## Patentansprüche

1. Festkörperbauelement mit einer Schicht, die eine erste Oberfläche und ein Muster elektrisch leitender Leitungen hierauf besitzt, wobei jede dieser Leitungen kristallographische Körner (42 bis 45) mit einer Vorzugsorientierung in gleicher kristallographischer Richtung besitzt, dadurch gekennzeichnet, daß die Kornstruktur im Form einer bambusförmigen Kette vorliegt und die Vorzugsorientierung im wesentlichen vollständig ist.

2. Festkörperbauelement nach Anspruch 1, bei dem die Körner in einer {111} Richtung orientiert sind.

3. Festkörperbauelement nach Anspruch 1 oder 2, bei dem die Schicht SiO₂ umfaßt und das Muster aus Aluminium oder einer Aluminiumlegierung aufgebaut ist.

4. Festkörperbauelement nach Anspruch 3, bei dem die SiO₂-Schicht auf einem Halbleitersubstrat gebildet ist.

5. Festkörperbauelement nach Anspruch 4, bei dem das Substrat Silicium ist.

6. Verfahren zum Herstellen eines Leiter-Musters auf einer Siliciumdioxid-Oberfläche, mit den Schritten
— Niederschlagen einer Schicht aus Aluminium oder einer Aluminiumlegierung auf die Oberfläche durch Elektronenkanonen-Verdampfung,
— Ätzen der Schicht zur Ausbildung des Musters und
— Auslagern der Schicht nach dem Ätzen, dadurch gekennzeichnet, daß
— die Schicht auf einer heiße Oberfläche niedergeschlagen wird und
— man bei einer Temperatur und für eine Zeitspanne auslagert, um eine Kornstruktur des Bambustyps auszubilden.

## Revendications

1. Un dispositif à l'état solide comprenant une couche ayant une première surface et un motif de lignes conductrices de l'électricité sur cette surface, chacune de ces lignes ayant des grains cristallographiques (42—45) orientés de façon préférentielle selon une même direction cristallographique, caractérisé en ce que la structure de grains se présente sous la forme d'une chaîne du type bambou et l'orientation préférentielle est pratiquement complète.

2. Un dispositif à l'état solide selon la revendication 1, dans lequel les grains sont orientés dans une direction {111}.

3. Un dispositif à l'état solide selon la revendications 1 ou 2, dans lequel la couche précitée consiste en SiO₂ et le motif est formé en aluminium ou en un alliage d'aluminium.

4. Un dispositif à l'état solide selon la revendication 3, dans lequel la couche de SiO₂ est formée sur un substrat semiconducteur.

5. Un dispositif à l'état solide selon la revendication 4, dans lequel le substrat est en silicium.

6. Un procédé pour former un motif conducteur sur une surface en dioxyde de silicium, comprenant les étapes qui consistent à déposer une couche d'aluminium ou d'un alliage d'aluminium sur la surface, par évaporation par faisceau d'électrons, à attaquer la couche pour former le motif et à recuire le couche après l'attaque, caractérisé en ce que la couche est déposée sur une surface chaude et l'opération de recuit est effectuée à une température et pendant une durée conduisant à la formation d'une structure de grains du type bambou.

## FIG. 1

PRIOR ART

13    GND    12    17

|←| mm   (45 THOU.)

## FIG. 3

## FIG. 5

| I | FORM SiO₂ LAYER ON SILICON SUBSTRATE |
| II | DEPOSIT Aℓ OR Aℓ COMPOUND LAYER BY e-BEAM EVAPORATION |
| III | DEVELOP PHOTO-RESIST PATTERN AND ETCH SUBSTRATE |
| IV | REMOVE PHOTO-RESIST AND ANNEAL AT 450°C FOR ½ HR. IN H₂ |

1

## FIG. 2

## FIG. 4

PRIOR ART

**FIG. 6**

Al-Cu

GROUP B

$t_{50}$(h)

GRAIN SIZE
GROUP B

GROUP A

STRIPE WIDTH ($\mu$m)

**FIG. 7**

MEDIAN TIME TO
FAILURE (HOURS)

C

Al2Si

$T = 80°C$
$J = 1 \times 10^5$ AMP/cm$^2$

—o— Al 2%Si, COLD DEPOSITED
—△— Al 1%Si .25%Cu, COLD DEPOSITED
—□— Al 1%Si .5%Cu, DEPOSITED AT 250°C
—▲— Al 1%Si .5%Cu, COLD DEPOSITED
—•— Al .5%Cu, DEPOSITED AT 330°C
--■-- Al .5%Cu, COLD DEPOSITED
--▽-- Al .5%Cu, EVAPORATED AT 330°C

LINE-WIDTH ($\mu$m)

*FIG. 8*

$$\frac{t_{50}(W\mu m)}{t_{50}(7\mu m)}$$

T = 80°C
J = 1×10⁵ A μm²

e-gun Aℓ - .5% Cu

IEEE PROCEEDINGS
(GROUP B)

S - gun Aℓ - 2% Si

THEORETICAL CURVE

*FIG. 9*

4